# EUROPÄISCHE PATENTSCHRIFT

(11) **EP 0 763 148 B1**
(45) Veröffentlichungstag und Bekanntmachung des Hinweises auf die Patenterteilung: **16.01.2002**
(21) Anmeldenummer: 95924157.1
(22) Anmeldetag: 26.06.1995
(51) Int. Cl.: C23C 16/44, C23C 16/54, C23C 16/30

(54) **REAKTOR UND VERFAHREN ZUM BESCHICHTEN VON FLÄCHIGEN SUBSTRATEN**
REACTOR AND PROCESS FOR COATING FLAT SUBSTRATES
REACTEUR ET PROCEDE PERMETTANT DE RECOUVRIR DES SUBSTRATS PLANS

(30) Priorität: 24.06.1994 DE 4422202
(43) Veröffentlichungstag der Anmeldung: 19.03.1997
(73) Patentinhaber: AIXTRON GMBH, 52072 Aachen (DE)
(72) Erfinder: JÜRGENSEN, Holger, 52072 Aachen (DE); BACHEM, Karl Heinz, Dr., 79199 Kirchzarten (DE)
(74) Vertreter: Münich, Wilhelm, Dr.
(86) Internationale Anmeldenummer: DE9500806
(87) Internationale Veröffentlichungsnummer: WO9600314

(56) Entgegenhaltungen:
- EP-A- 0 448 346
- FR-A- 2 366 871
- PATENT ABSTRACTS OF JAPAN vol. 014 no. 531 (C-0780) ,21.November 1990 & JP,A,02 221399 (C UYEMURA & CO LTD) 4.September 1990,
- J.ELECTRONIC MATERIALS, Bd. 17, Nr. 5, September 1988 USA, Seiten 381-386, PUETZ ET AL. 'The Inverted Horizontal Reactor: Growth of Uniform InP and GaInAs by LPMOCVD'
- JOURNAL OF CRYSTAL GROWTH, Bd. 107, Nr. 1 / 04, 1.Januar 1991 Seiten 370-375, XP 000246625 KIKKAWA T ET AL 'MOVPE GROWTH OF UNIFORM ALGAAS AND INGAAS USING ORGANOARSINE WITH INVERTED-HORIZONTAL ATMOSPHERIC-PRESSURE REACTOR'

## Beschreibung

### Technisches Gebiet

Die Erfindung bezieht sich auf einen Reaktor zur Beschichtung von flächigen Substraten gemäß dem Oberbegriff des Patentanspruchs 1 sowie auf Verfahren zur Herstellung von flächigen Substaten unter Verwendung gattungsgemäßer Reaktoren.

### Stand der Technik

Reaktoren zur Beschichtung von Substraten unter Verwendung von CVD-Prozessen und insbesondere MOCVD-Prozessen sowie Plasmabeschichtungsprozessen erfordern eine Reaktionsgas-Strömung durch das sogenannte Reaktor- bzw. Reaktionsgefäß, in dem das bzw. die zu beschichtenden Substrate angeordnet sind. Um eine hervorragende Beschichtung der Oberfläche der Substrate zu erreichen, ist es erforderlich, den Reaktionsgasstrom möglichst gleichmäßig, d.h. in laminarer Strömung, derart nahe an der Substratoberfläche vorbeizuleiten, daß eine möglichst homogene Schichtenbildung auf dem Substrat erfolgt.

Bei der Herstellung "üblicher" Schichten sind jedoch während des Beschichtungsverfahrens hohe Temperaturen erforderlich, die u.a. zu Wärmekonvektionseffekten innerhalb des Gasstromes und damit zu einer Störung der laminaren Strömung führen. Zwar ist es möglich durch eine erhöhte Reaktionsgasstromgeschwindigkeit die Laminarität und damit die Parallelität des Reaktionsgasstromes relativ zur Beschichtungsoberfläche zu steigern, doch können gleichwohl auch transversale Strömungskomponenten innerhalb des Reaktionsgefäßes bedingt durch Konvektion, aber auch durch konstruktive Hindernisse, die dem Reaktionsgasstrom im Wege stehen, auftreten. Derartige transversale Strömungskomponenten führen innerhalb des Reaktorgefäßes zu lokalen Wirbelbildungen (Vortex), die den Beschichtungsprozeß negativ beeinflussen.

Durch die auftretenden turbulenten Strömungsbereiche läßt sich auch erklären, daß die Schichtenbildung auf dem vorzugsweise flächig ausgestalteten Substrat nicht gleichmäßig erfolgt, sondern daß Stellen mit höherer Schichtablagerung und Stellen mit niedrigerer Schichtablagerung auftreten.

Ferner treten bei den bekannten Reaktorsystemen, bei denen die zu beschichtenden Substrate auf dem Boden des Reaktionsgefäßes angeordnet sind, Oberflächeneffekte auf, die von Kondensatabscheidungen herrühren, die sich während des Beschichtungsprozesses an den Reaktorwänden bilden und je nach Kondensatmenge von den oberen Reaktorwänden nach unten fallen und die Oberfläche des Substrates beschädigen.

### Darstellung der Erfindung

Der Erfindung liegt die Aufgabe zugrunde, einen Reaktor zur Beschichtung von flächigen Substrates und insbesondere von Wafern, bei dem ein hoher Durchsatz bei homogener Schichtbildung möglich ist, sowie ein Verfahren zur Herstellung derartiger Substrate anzugeben, das die Herstellung der verschiedensten Substrate erlaubt.

Eine erfindungsgemäße Lösung dieser Aufgabe ist mit ihren Weiterbildungen in den Patentansprüchen angegeben.

Erfindungsgemäß wird von einem Reaktor ausgegangen, wie er im Oberbegriff des Patentanspruchs 1 vorausgesetzt ist, und wie er von der Fraunhofer-Gesellschaft zur Förderung der angewandten Forschung e.V. vorgeschlagen worden ist.

Dieser von der Fraunhofer-Gesellschaft vorgeschlagene Reaktor, für dessen prinzipielle Ausbildung im Rahmen der vorliegenden Anmeldung kein Schutz begehrt wird, weist ein Reaktor- bzw. Reaktionsgefäß auf, in das Reaktionsgase sowie gegebenenfalls ein Trägergas einleitbar sind. In dem Reaktionsgefäß ist wenigstens ein Substrat derart angeordnet, daß eine Hauptoberfläche des Substrats im wesentlich parallel zur Strömungsrichtung der Reaktionsgase ausgerichtet ist.

Zur Erhöhung des Durchsatzes sind auf der Substrathaltereinheit wenigstens zwei Plätze für Substrate vorgesehen. Der oder die Halter sind in Art einer Schablone ausgebildet, die Öffnungen für die zu beschichtenden Oberflächen _ der Substrate aufweist.

Erfindungsgemäß wird ausgenutzt, daß konvektive Transversalströmungen innerhalb eines Reaktorgefäßes während des Beschichtungsvorganges dadurch vermieden werden können, daß das zu beschichtende Substrat im Bereich oder an der oberen Gefäßkammer derart angebracht ist, so daß die zu beschichtende Hauptoberfläche nach unten orientiert ist.

Vortex-Bildungen innerhalb des Strömungskanales können auf diese Weise ausgeschlossen worden. Ebenso ist durch die erfindungsgemäße Substratorientierung die Beschädigungsgefahr durch auf die Substratoberfläche auftreffende Kondensatteilchen praktisch ausgeschlossen.

Erfindungsgemäß trägt die rotierbar gelagerte Trageringhalterung, die das Substrat faßt, dazu bei, daß die Reaktionsgasströmung, die unter Umständen innerhalb des laminaren Stromflusses Inhomogenitäten aufweist, möglichst gleichmäßig an der Substratoberfläche anliegt. Damit ist eine im Mittel homogene Schichtenbildung auf dem Substrat möglich.

Grundsätzlich ist der Reaktor derart ausgebildet, daß ein ein Reaktorgehäuse vorgesehen ist, innerhalb dem das Reaktor- bzw. Reaktionsgefäß enthalten ist, in dem der Beschichtungs-vorgang stattfindet. Die Reaktionsgase durchströmen das Reaktorgefäß innerhalb eines geschlossenen Kreislaufes und beschichten dabei die innerhalb des Reaktorgefäßes eingebrachten und angebrachten Substratflächen. Das Reaktorgehäuse selbst ist wiederum mit einem Schleusengehäuse verbunden, das ein Kassettengehäuse aufweist, innerhalb dem die zu beschichtenden Substrate angeordnet sind, die bei Bedarf und aus Gründen eines vollautomatisierten Beschichtungsablaufes die Substrate speichern. Zur Speicherung der Substrate dient ein Kassettenlader, in dem die Substratflächen samt Tragering abgelegt werden können.

Desweiteren ist das Kassettengehäuse durch ein daran unmittelbar angebrachtes Schleusengehäuse befüllbar. Der Anschluß zwischen Schleusengehäuse und Kassettengehäuse sowie Kassettengehäuse und Reaktorgehäuse erfolgt über gasdicht verschließende Ventile, so daß für den Bediener der Anlage sichergestellt ist, daß dieser nicht in Kontakt mit den gasatmosphärischen Bedingungen innerhalb des Reaktorgefäßes tritt.

Der vorstehend beschriebene Reaktor eignet sich zur Herstellung der verschiedensten Materialien: nicht nur III-IV- Schichten, sondern auch II-VI-Halbleiterschichten, SiC, SiGe, Oxide, supraleitende Materialien etc. können hergestellt werden.

Dabei können die Prozeßdrücke unterhalb oder oberhalb von 100 mBar liegen.

### Kurze Beschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:
- Fig. 1: schematische Gegenüberstellung der Strömungsverhältnisse innerhalb eines Reaktorgefäßes und
- Fig. 2: schematische Gesamtdarstellung der Reaktoranordnung samt Kassetten- und Schleusen- _ gehäuse.

### Darstellung von Ausführungsbeispielen

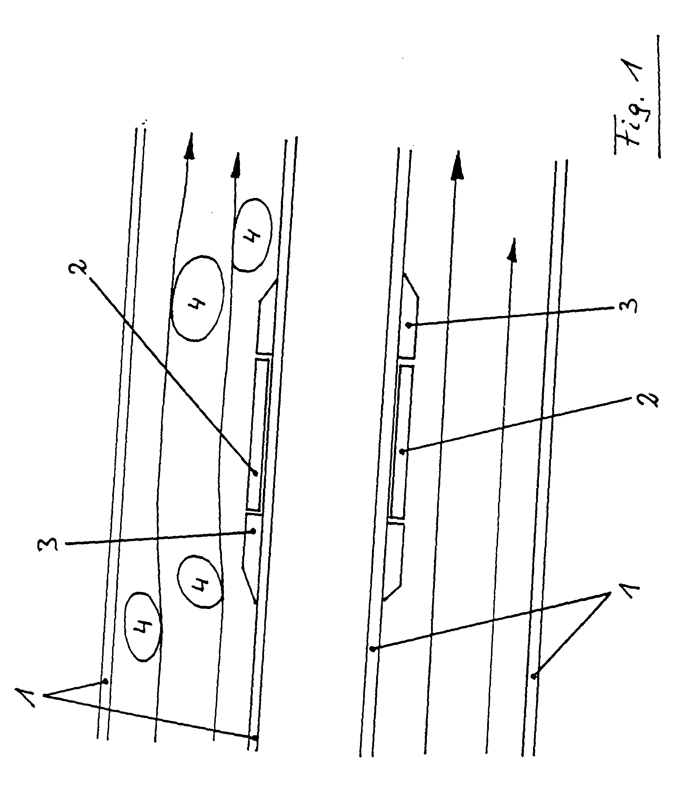

In Figur 1 geht aus der oberen Darstellung ein Querschnitt des Reaktorgefäßes 1 hervor, innerhalb dem sich ein Reaktionsgasstrom (siehe Strömungspfeile) befindet. Das zu beschichtende Substrat 2 ist innerhalb eines Trageringes 3 befestigt und ist mit seiner zu beschichtenden Hauptoberfläche nach oben orientiert. Durch Konvektionsprozesse bilden sich innerhalb des stromführenden Kanals Turbulenzwirbel 4 aus, die eine gleichmäßige Beschichtung des Substrates 2 verhindern.

Im Gegensatz zur oberen Darstellung der Figur 1 ist aus der unteren Darstellung die Anordnung des zu beschichtenden Substrates innerhalb des Trageringes 3 derart angebracht, daß die zu beschichtende Schicht nach unten orientiert ist. Als Folge hiervon sind keine Wirbelbildungen zu beobachten; die laminare Strömung des Reaktionsgases wird in Folge von Konvektionsprozessen nicht gestört, so daß eine gleichmäßige Schichtablagerung erfolgen kann.

Erfindungsgemäß sind auf der Substrathaltereinheit wenigstens zwei Plätze für Substrate vorgesehen. Dabei ist der oder die Halter in Art einer Schablone ausgebildet sind, die Öffnungen für die zu beschichtenden Oberflächen der Substrate aufweist.

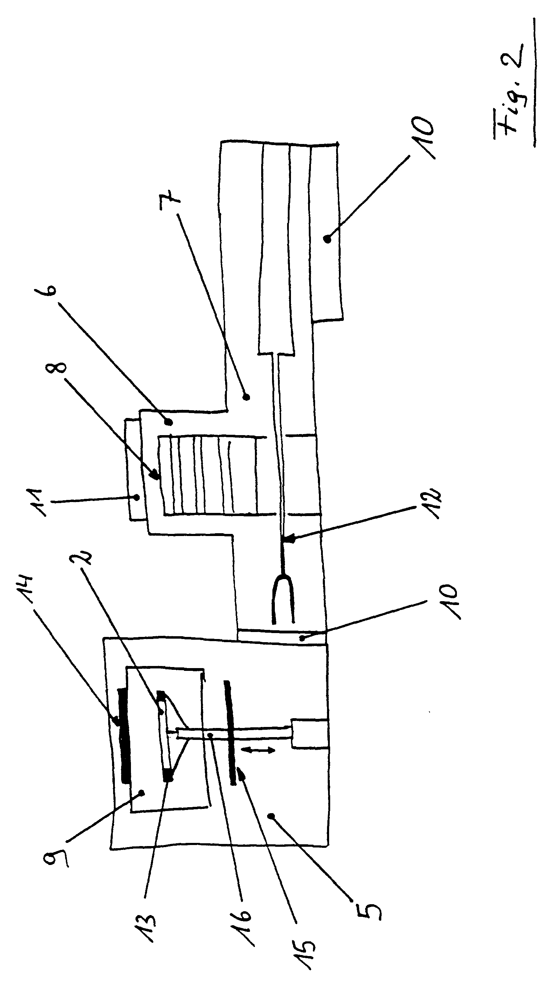

In Figur 2 ist eine schematisierte Darstellung der vollständigen Reaktorkomponenten dargestellt, die grundsätzlich ein Reaktorgehäuse 5, ein Kassettengehäuse 6 und ein Schleusengehäuse 7 aufweisen. Das flächige Substrat 2, das selbst in einem Tragering 13 gefaßt ist, befindet sich, nachdem es für den Beginn eines Beschichtungsvorganges durch ein Schleusengehäuse 7 in das Kassettengehäuse 6 eingebracht ist, innerhalb eines Kassettenladers 8. Das Substrat 2 samt Tragering 13 wird durch ein Ventil 10, das das Reaktorgehäuse 5 mit dem Kassettengehäuse 6 verbindet, in das Reaktorgehäuse 5 verbracht, von wo es in das Reaktorgefäß 9 eingeschleust wird. Das Einschleusen des Substrates 2 samt Tragering 13 in das Reaktorgefäß 9 wird durch einen Gabelarm 12 realisiert, der in Eingriff mit dem Tragering 13 steht und den Tragering samt Substrat aus dem Kassettenlader 8 entnimmt und in einer Linearführung durch eine Ladeschleuse (10) innerhalb des Reaktorgehäuses 9 verbringt. Die Positionierung des Substrates 2 erfolgt derart unter eine Öffnung des Reaktorgefäß 2, so daß ein Aufnahmerarm 16 vertikal von unten an den Tragering 13 mittels drei Finger angreift und diesen samt Substrat 2 vertikal nach oben durch die Öffnung des Reaktorgefäßes verbringt (siehe vertikalen Translationspfeil). Der Aufnahmearm 15, der zugleich auch die Drehachse des Substrates definiert, drückt das Substrat über den Tragering mit seiner oberen Fläche gegen eine im oberen Wandabschnitt vorgesehene, beheizbare Graphitplatte 14.

Die, vorzugsweise aus Quarz gefertigten drei Finger des vertikalen Aufnahmearms münden nach unten in einer gemeinsamen zentralen Achse 16, die zugleich Drehachse für das Substrat ist. Diese Achse ist gasdicht aber drehbar durch eine untere Quarzplatte 15 geführt, die in ihren Abmessungen etwas größer ausgestaltet ist als die untere Öffnung des Reaktorgefäßes 9, durch die das Substrat 2 in das Reaktorgefäß 9 eingeführt worden ist, und verschließt diese Öffnung gasdicht nach unten hin.

In der bevorzugten Ausführungsform gemäß Figur 2 handelt es sich um einen horizontalen Rechteckrohrreaktor für 2"-,3"- und 4"-Substrate, welcher aus einem druck-und vakkumdichten Gehäuse aus geschmiedetem Aluminium mit angeflanschter Lademaschine aus gleichem Material besteht. Die angeflanschte Lademaschine entspricht dem bereits vorgestellten Kassettengehäuse, in dem die zu beschichtenden Substrate im Rahmen eines Kassettenladers gestapelt sind. Nach Beendigung der Beladung der Substrate innerhalb des Reaktorgefäßes beginnen die Substrate, die auf einem Tragering fixiert sind, zu rotieren, so daß in der beschriebenen Art und Weise eine gleichmäßige Schichtablagerung erfolgt. Nach Beendigung der Beschichtung wird in das Reaktorgefäß Wasserstoff mit freiwählbarem Druck eingeleitet, so daß der Reaktor, der immer noch auf ca. 400° temperiert ist, geöffnet werden kann und der Substratwechsel vorgenommen werden kann. Der Substratwechsel erfolgt bei Verwendung eines Kassettenladers in ca 8 Minuten, wohingegegn 15 Minuten benötigt werden, sofern die Substrate ohne Kassettenlader in das Reaktorgefäß verbracht werden. Durch Benutzung des Kassettenladers ist der Beschichtungsbetrieb voll automatisch möglich.

Darüberhinaus weist die Reaktoranordnung gemäß Figur 2 Ventile 10 auf, die für einen gasdichten Anschluß der dargestellten Gehäuseteile sorgen. Das Kassettengehäuse 6 ist ferner über eine Ladetür 11 mit den Substraten schnell zu bestücken.

Mit dem erfindungsgemäßen Reaktor ist ein Reaktor angegeben, der für Forschung, Entwicklung und Produktion gleichermaßen geeignet ist. Als besonders vorteilhaft hat es sich erwiesen, daß eine Beladevorrichtung, die den Tragering für das Substrat aufweist zugleich Teil des Abdichtungssystems des Reaktorgefäßes ist, so daß das Austreten von Reaktionsgasen aus dem Inneren des Reaktors nach außen verhindert werden kann.

Mit der besonders vorteilhaft ausgestalteten Translationskinematik der Substratverfrachtung zwischen den einzelnen Prozeßstationen ist es erstmals gelungen den Beschichtungsablauf vollautomatisch durführen zu können.

## Patentansprüche

1. Reaktor zur Beschichtung von flächigen Substraten und insbesondere von Wafern, mit
- einem Reaktionsgefäß, in das Reaktionsgase einleitbar sind, und
- einer Substrathaltereinheit, in der mindestens ein Substrat in mindestens einem Halter derart gehalten ist, daß die zu beschichtende Hauptoberfläche des Substrats während des Depositionsvorganges nach unten orientiert und im wesentlichen parallel zur Strömungsrichtung der Reaktionsgase ausgerichtet ist, **dadurch gekennzeichnet,**
- **daß** auf der Substrathaltereinheit mindestens ein Platz für mindestens ein Substrat vorgesehen ist,
- **daß** der mindestens eine Halter in Art einer Schablone ausgebildet ist, die mindestens eine Öffnung für die zu beschichtende Oberfläche des mindestens einen Substrates aufweist,
- **daß** die Oberfläche des mindestens einen Halters wenigstens annähernd bündig mit der Oberfläche des mindestens einen Substrates verläuft,
- **daß** der mindestens eine Halter gemeinsam mit dem mindestens einen Substrat in den Reaktor einführbar und aus diesem wieder entnehmbar ist, und
- **daß** der mindestens eine Halter an seiner Unterseite von drei Fingern getragen wird, die in eine gemeinsame zentrale Achse münden, wobei die Achse gleichzeitig Drehachse für das mindestens eine Substrat ist und zugleich zur Beladung des Reaktionsgefäßes mit dem mindestens einen Substrat von unten seitlich zur Strömungsrichtung der Reaktionsgase dient.

2. Reaktor nach Anspruch 1,
**dadurch gekennzeichnet, daß** für wenigstens zwei Substrate ein gemeinsamer Halter vorgesehen ist.

3. Reaktor nach Anspruch 1,
**dadurch gekennzeichnet, daß** bei mehreren Substraten für jedes Substrat ein eigener Halter vorgesehen ist.

4. Reaktor nach dem Oberbegriff des Anspruchs 1 oder nach einem der Ansprüche 1 bis 3,
**dadurch gekennzeichnet, daß** die Substrathaltereinheit(en) um eine Achse rotieren.

5. Reaktor nach einem der Ansprüche 1 bis 4,
**dadurch gekennzeichnet, daß** eine Beladevorrichtung vorgesehen ist, die den oder die Halter und die jeweils von ihnen getragenen Substrate in den Reaktor einführt und wieder entnimmt.

6. Reaktor nach Anspruch 5,
**dadurch gekennzeichnet, daß** ein Kassettenspeicher vorgesehen ist, aus dem die Beladevorrichtung die Halter zusammen mit den Substraten entnimmt, so daß ein vollautomatischer Schichtbetrieb möglich ist.

7. Reaktor nach einem der Ansprüche 1 bis 6,
**dadurch gekennzeichnet, daß** der Reaktor ein horizontaler Rechteckrohrreaktor ist.

8. Reaktor nach einem der Ansprüche 1 bis 7,
**dadurch gekennzeichnet, daß** der Reaktor ein druck- und vakuumdichtes Gehäuse aus geschmiedetem Aluminium aufweist.

9. Reaktor nach einem der Ansprüche 1 bis 7,
**dadurch gekennzeichnet, daß** die Reaktorbaumaterialien Quarz und Molybdän und kein Graphit aufweisen.

10. Reaktor nach einem der Ansprüche 1 bis 8,
**dadurch gekennzeichnet, daß** der oder die Halter die Substrate an eine beheizbaren Graphit- oder Molybdänplatte andrücken.

11. Reaktor nach einem der Ansprüche 1 bis 10,
**dadurch gekennzeichnet, daß** der oder die Halter Sensoren für eine in-situ-Überwachung des Beschichtungsprozesses aufweisen.

12. Reaktor nach einem der Ansprüche 1 bis 11,
**dadurch gekennzeichnet, daß** ein Lampen- und/oder ein RF-Heizsystem vorgesehen ist, das mehrere Heizelemente aufweist, die einzeln oder in Untergruppen zur Verbesserung der Temperaturhomogenität ansteuerbar sind.

13. Reaktor nach einem der Ansprüche 1 bis 12,
**dadurch gekennzeichnet, daß** eine Aufnahmegabel vorgesehen ist, die, am Tragering angreifend, das Substrat aus dem Kassettenspeicher entnimmt und in eine Position unterhalb einer Öffnung in dem Reaktorgefäß überführt.

14. Reaktor nach Anspruch 13,
**dadurch gekennzeichnet, daß** ein Aufnahmearm, der mehrere aus Quarz gefertigte Finger aufweist, am Tragering von unten angreift und diesen vertikal nach oben in das Reaktorgefäß an eine Stelle hebt.

15. Reaktor nach Anspruch 14,
**dadurch gekennzeichnet, daß** der Aufnahmearm zugleich die Drehachse des Substrates während des Beschichtungsprozesses darstellt.

16. Verwendung eines Reaktors nach einem der Ansprüche 1 bis 15,
**dadurch gekennzeichnet, daß** der Reaktor ein Multi-Purpose-Reaktor ist, der [insbesondere] auch zur Herstellung von II-VI-Schichten nach dem MOCVD-Verfahren dient.

17. Verfahren zum Beschichten von Substraten unter Verwendung eines Reaktors, der
- ein Reaktionsgefäß, in das Reaktionsgase einleitbar sind, und
- eine Substrathaltereinheit aufweist, in der mindestens ein Substrat in mindestens einem Halter derart gehalten ist, daß die zu beschichtende Hauptoberfläche des mindestens einen Substrates während des Depositionsvorganges nach unten orientiert und im wesentlichen parallel zur Strömungsrichtung der Reaktionsgase ausgerichtet ist, oder nach Anspruch 19, **dadurch gekennzeichnet, daß** der Reaktor
- wenigstens einen Aufnahmearm aufweist, der das mindestens eine Substrat Samt Halter an die obere Wandfläche des Reaktionsgefäßes andrückt, und daß das mindestens eine Substrat durch den Aufnahmearm während des Beschichtungsvorganges gedreht wird.

18. Verfahren nach Anspruch 17,
**dadurch gekennzeichnet, dass** der Aufnahmearm zugleich Teil des Abdichtungssystems des Reaktorgefäßes ist.

19. Verfahren zum Beschichten von Substraten unter Verwendung eines Reaktors, der
- ein Reaktionsgefäß, in das Reaktionsgase einleitbar sind,
- eine Substrathaltereinheit aufweist, in der mindestens ein Substrat in mindestens einem Halter derart gehalten ist, daß die zu beschichtende Hauptoberfläche des Substrates während des Depositionsvorganges nach unten orientiert und im wesentlichen parallel zur Strömungsrichtung der Reaktionsgase ausgerichtet ist,
**gekennzeichnet, durch**
- Einbringen des mindestens einen Substrats in den mindestens einen Halter, der als eine Art Schablone mit mindestens einer Öffnung für die zu beschichtende Oberfläche des mindestens einen Substrats ausgebildet ist, wobei damit für das mindestens eine Substrat mindestens ein Platz auf der Substrathaltereinheit vorgesehen ist,
- wenigstens annähernd bündiges Positionieren der Oberfläche des mindestens einen Substrats mit der Oberfläche des mindestens einen Halters,
- Tragen des mindestens einen Halters an seiner Unterseite **durch** drei Finger, die in eine gemeinsame zentrale Achse münden,
- von unten seitlich zur Strömungsrichtung der Reaktionsgase erfolgendes Beladen des Reaktionsgefäßes mit dem mindestens einen Substrat, wobei der mindestens eine Halter gemeinsam mit dem mindestens einen Substrat in den Reaktor eingeführt wird,
- Drehen des mindestens einen Substrates um die gemeinsame zentrale Achse, und
- gemeinsames Entnehmen des mindestens einen Halters mit dem mindestens einen Substrat aus dem Reaktor.

20. Verfahren nach einem der Ansprüche 17 bis 19,
**gekennzeichnet**, daß ein Trägergas eingeleitet wird, und daß II-VI-Halbleiterschichten hergestellt werden.

21. Verfahren nach einem der Ansprüche 17 bis 20,
**dadurch gekennzeichnet, daß** mit Prozeßdrücken ≥ 100 mbar gearbeitet wird.

22. Verfahren nach einem der Ansprüche 17 bis 20,
**dadurch gekennzeichnet, daß** mit Prozeßdrücken ≤ 100 mbar gearbeitet wird.

## Claims

1. Reactor for coating flat substrates and wafers in particular, comprising
- a reaction vessel adapted for the introduction of reaction gases and
- a substrate holder unit in which at least one substrate is held in at least one holder in such a way that the principal surface of said substrate, that is to be coated, is oriented in a downward direction during the depositing operation and is directed substantially in parallel with the flow direction of the reaction gases, **characterised in**
- **that** said at least one holder is configured in the manner of a jig presenting at least one opening for the surface of said at least one substrate, that is to be coated,
- **that** the surface of said at least one holder extends at least approximately flush with the surface of said at least one substrate,
- **that** said at least one holder is adapted to be introduced into and removed from the reactor jointly with said at least one substrate, and
- **that** said at least one holder is supported by three fingers at its underside, which terminate in a common central axis, with this axis being the axis of rotation for said at least one substrate at the same time and serves simultaneously for charging said reaction vessel with said at least one substrate from below and laterally of the direction of flow of the reaction gases.

2. Reactor according to Claim 1,
**characterised in that** a common holder is provided for at least two substrates.

3. Reactor according to Claim 1,
**characterised in that** in the case of several substrates a separate holder is provided for each substrate.

4. Reactor according to the introductory clause of Claim 1 or according to any of the Claims 1 to 3,
**characterised in that** said substrate holder unit(s) rotate(s) about an axis.

5. Reactor according to any of the Claims 1 to 4,
**characterised in that** a charging device is provided that introduces and removes said holder(s) and the respective substrate(s) held by it or them into and from said reactor.

6. Reactor according to Claim 5,
**characterised in that** a cartridge storing means is provided from which said charging device removes said holders together with said substrates such that a fully automatic operation in shifts will be possible.

7. Reactor according to any of the Claims 1 to 6,
**characterised in that** the reactor is a horizontal rectangular tube reactor.

8. Reactor according to any of the Claims 1 to 7,
**characterised in that** the reactor comprises a housing of wrought aluminium, that is tight in terms of pressure and vacuum.

9. Reactor according to any of the Claims 1 to 7,
**characterised in that** the materials used for the production of the reactor contain quartz and molybdenum and are free of graphite.

10. Reactor according to any of the Claims 1 to 8,
**characterised in that** said holder(s) press said substrates against a heatable graphite or molybdenum plate.

11. Reactor according to any of the Claims 1 to 10,
**characterised in that** said holder(s) comprise(s) sensors for in-situ monitoring of the coating operation.

12. Reactor according to any of the Claims 1 to 11,
**characterised in that** a lamp and/or an RF heating system is provided that includes a plurality of heating elements adapted to be controlled individually or in sub-groups for improving the homogeneity in terms of temperature.

13. Reactor according to any of the Claims 1 to 12,
**characterised in that** a receiving fork is provided which, engaged on said supporting ring, removes said substrate from said cartridge storing means and transfers it into a position below an opening in said reactor vessel.

14. Reactor according to Claim 13,
**characterised in that** a receiving arm including a plurality of fingers made of quartz engages on said supporting ring from below and lifts it vertically upward into said reactor vessel at one position.

15. Reactor according to Claim 14,
**characterised in that** said receiving arm is at the same time the axis of rotation of said substrate during the coating process.

16. Application of a reactor according to any of the Claims 1 to 15,
**characterised in that** the reactor is a multi-purpose reactor that serves [in particular] also for the production of II-VI strata with application of the MOCVD method.

17. Method of coating substrates by using a reactor comprising
- a reaction vessel adapted for the introduction of reaction gases and
- a substrate holder unit in which at least one substrate is held in at least one holder in such a way that the principal surface of said substrate, that is to be coated, is oriented in a downward direction during the depositing operation and is directed substantially in parallel with the flow direction of the reaction gases, or according to Claim 14,
**characterised in that** the reactor
- comprises at least one receiving arm that presses said at least one substrate together with the holder against the upper wall surface of said reaction vessel, and
- that at least one substrate is rotated by said receiving arm during the coating process.

18. Method according to Claim 17,
**characterised in that** said receiving arm is, at the same time, part of the sealing system of said reaction vessel.

19. Method of coating substrates by using a reactor comprising
- a reaction vessel adapted for the introduction of reaction gases and
- a substrate holder unit in which at least one substrate is held in at least one holder in such a way that the principal surface of said substrate, that is to be coated, is oriented in a downward direction during the depositing operation and is directed substantially in parallel with the flow direction of the reaction gases,
**characterised by**
- introducing said at least one substrate into said at least one holder that is configured in the manner of a jig presenting at least one opening for the surface of said at least one substrate, that is to be coated, with at least one position being hence provided on said substrate holder unit for said at least one substrate,
- by positioning of the surface of said at least one substrate at least approximately flush with the surface of said at least one holder,
- supporting said at least one holder on the underside thereof by three fingers terminating in a common central axis,
- by charging said reaction vessel with said at least one substrate from below, laterally of the direction of flow of the reaction gases, with said at least one holder being introduced into the reactor jointly with said at least one substrate,
- by rotating said at least one substrate about said common central axis, and
- by removing said at least one holder together with said at least one substrate from the reactor.

20. Method according to any of the Claims 17 to 19,
**characterised in that** a carrier gas is introduced, and that II-VI semiconductor layers are produced.

21. Method according to the Claims 17 to 20,
**characterised in that** the operation is carried out at process pressures of ≥ 100 mbar.

22. Method according to any of the Claims 17 to 20,
**characterised in that** the operation is carried out at process pressures of ≤ 100 mbar.

## Revendications

1. Réacteur à recouvrir des substrats plans et des galettes, en particulier, comprenant
- un réacteur approprié à l'introduction des gaz de réaction et
- une unité à élément porte-substrat, dans laquelle au moins un substrat est tenu de façon, que la surface principale dudit substrat, qu'on doit recouvrir, est orientée en direction en bas au cours de l'opération de dépôt, en étant orientée essentiellement en parallèle au sens d'écoulement des gaz de réaction, **caractérisé en ce**
- **qu'**au moins un élément porte-substrat est configuré de la manière d'un gabarit ayant au moins une ouverture pour la surface dudit au moins un substrat, qui est à recouvrir,
- en ce que la surface dudit au moins un élément porte-substrat s'étend à fleur, au moins approximativement, de la surface dudit au moins un substrat,
- en ce que ledit au moins un élément porte-substrat est approprié à être introduit dans et retiré du réacteur ensemble avec ledit au moins un substrat, et
- en ce que ledit au moins un élément porte-substrat est appuyé par trois doigts de son côté inférieur, qui se terminent dans un axe central commun, qui est, en même temps, l'axe de rotation pour ledit au moins un substrat, en servant à charger ledit au moins un substrat dans ledit réacteur d'en bas et latéralement de la direction d'écoulement des gaz de réaction.

2. Réacteur selon la revendication 1,
**caractérisé en ce qu'**un élément porte-substrat commun est disposé pour au moins deux substrats.

3. Réacteur selon la revendication 1,
**caractérisé en ce qu'**au cas d'une pluralité de substrats, un élément porte-substrat séparé est disposé pour chacun substrat.

4. Réacteur selon le préambule de la revendication 1 ou selon une quelconque des revendications 1 à 3,
**caractérisé en ce que** la/les unité(s) aux éléments porte-substrat tourne(ent) autour d'un axe.

5. Réacteur selon une quelconque des revendications 1 à 4,
**caractérisé en ce qu'**un dispositif de chargement est disposé, qui introduit **et** retire le(s)dit(s) élément(s) porte-substrat et le(s) substrat(s) respectif(s) y porté(s) dans ledit ou dudit réacteur.

6. Réacteur selon la revendication 5,
**caractérisé en ce qu'**un dispositif de stockage de cassettes est disposé, duquel ledit dispositif de chargement retire lesdits éléments porte-substrat, ensemble avec lesdits substrats, de façon à permettre un fonctionnement entièrement automatisé.

7. Réacteur selon une quelconque des revendications 1 à 6,
**caractérisé en ce que** le réacteur est un réacteur à tube rectangulaire horizontal.

8. Réacteur selon une quelconque des revendications 1 à 7,
**caractérisé en ce que** le réacteur comprend un carter en aluminium forgé, qui est étanche aux pressions et au vide.

9. Réacteur selon une quelconque des revendications 1 à 7,
**caractérisé en ce que** les matériaux utilisés pour la construction du réacteur contiennent du quartz et du molybdène, en étant exempt de graphite.

10. Réacteur selon une quelconque des revendications 1 à 8,
**caractérisé en ce que** le(s)dit(s) élément(s) porte-substrat presse(nt) lesdits substrats contre une plaque chauffable en graphite ou molybdène.

11. Réacteur selon une quelconque des revendications 1 à 10,
**caractérisé en ce que** le(s)dit(s) éléments porte-substrat comprend/comprennent des détecteurs pour la surveillance in situ du processus de recouvrement.

12. Réacteur selon une quelconque des revendications 1 à 11,
**caractérisé en ce qu'**une lampe et/ou un système de chauffage RF est monté, qui comprend une pluralité des éléments chauffeurs, qui sont appropriés à être commandé individuellement ou par sous-groupes afin d'améliorer l'homogénéité en ce qui concerne la température.

13. Réacteur selon une quelconque des revendications 1 à 12,
**caractérisé en ce qu'**une fourche recevante est disposée, qui, en prise sur ledit anneau porteur, enlève ledit substrat desdits moyens de stockage des cassettes et le transfère dans une position au-dessous d'une ouverture dans ledit réacteur.

14. Réacteur selon la revendication 13,
**caractérisé en ce qu'**un bras recevant, comprenant une pluralité de doigts faits en quartz, se met en prise sur ledit anneau porteur d'en bas et le relève en sens vertical en haut dans ledit réacteur à une position.

15. Réacteur selon la revendication 14,
**caractérisé en ce que** ledit bras recevant est, en même temps, l'axe de rotation dudit substrat au cours du processus de recouvrement.

16. Application d'un réacteur selon une quelconque des revendications 1 à 15,
**caractérisée en ce que** le réacteur est un réacteur à usages multiples, qui sert [en particulier] aussi à la fabrication des couches II-VI par application du processus MOCVD.

17. Processus de recouvrement des substrats en employant un réacteur comprenant:
- un réacteur apte à être alimenté en gaz de réaction et
- une unité à élément porte-substrat, dans laquelle au moins un substrat est tenu dans au moins un élément porte-substrat de façon, que la surface principale dudit substrat, qui est à recouvrir, soit orientée en une direction en bas au cours de l'opération de dépôt, en étant dirigée essentiellement en parallèle au sens d'écoulement des gaz de réaction, ou selon la revendication 14,
**caractérisé en ce que** le réacteur
- comprend au moins un bras recevant, qui presse ledit au moins un substrat, ensemble avec l'élément porte-substrat, contre la surface de la paroi supérieure dudit réacteur, et
- **en ce qu'**au moins un substrat est tourné par ledit bras recevant au cours du processus de revêtement.

18. Processus selon la revendication 17,
**caractérisé en ce que** ledit bras recevant constitue, en même temps, un élément du système d'étanchéité dudit réacteur.

19. Processus de recouvrement des substrats en utilisant un réacteur comprenant:
- un réacteur approprié à être alimenté en gaz de réaction, et
- une unité à élément porte-substrat, dans laquelle au moins un substrat est tenu dans au moins un élément porte-substrat, de façon, que la surface principale dudit substrat, qui est à recouvrir, soit orientée en une direction en bas au cours de l'opération de dépôt, en étant dirigée essentiellement en parallèle au sens d'écoulement des gaz de réaction,
**caractérisé par**
- l'introduction dudit au moins un substrat dans ledit au moins un élément porte-substrat, qui est configuré de la manière d'un gabarit ayant au moins une ouverture pour la surface dudit au moins un substrat, qui est à recouvrir, à au moins une position étant donc envisagée sur ladite unité à élément porte-substrat pour ledit au moins un substrat.
- le positionnement de la surface dudit au moins un substrat, au moins de façon approximative, à fleur de la surface dudit au moins un élément porte-substrat,
- le support dudit au moins un élément porte-substrat de son côté inférieur moyennant trois doigts, qui se terminent dans un axe central commun,
- le chargement dudit au moins un substrat dans ledit réacteur d'en bas, latéralement de la direction d'écoulement des gaz de réaction, ledit au moins un élément porte-substrat étant introduit dans le réacteur ensemble avec ledit au moins un substrat,
- la rotation dudit au moins un substrat autour dudit axe central commun, et
- la retraite dudit au moins un élément porte-substrat, ensemble avec ledit au moins un substrat, en dehors du réacteur.

20. Processus selon une quelconque des revendications 17 à 19,
**caractérisé en ce qu'**un gaz vecteur est introduit, et **en ce qu'**on produit des couches semi-conductrices II-VI.

21. Processus selon les revendications 17 à 20,
**caractérisé en ce que** le processus est réalisé aux pressions de régime of ≥ 100 mbar.

22. Processus selon les revendications 17 à 20,
**caractérisé en ce que** le processus est réalisé aux pressions de régime de ≤ 100 mbar.
